(19) Europäisches Patentamt / European Patent Office / Office européen des brevets

(11) **EP 4 357 491 A1**

(12) **EUROPEAN PATENT APPLICATION**
published in accordance with Art. 153(4) EPC

(43) Date of publication:
**24.04.2024 Bulletin 2024/17**

(21) Application number: **22824700.3**

(22) Date of filing: **02.05.2022**

(51) International Patent Classification (IPC):
*C30B 29/04* (2006.01)   *B23B 27/14* (2006.01)
*B23B 27/20* (2006.01)   *C30B 9/10* (2006.01)
*C30B 33/04* (2006.01)

(52) Cooperative Patent Classification (CPC):
**B23B 27/14; B23B 27/20; C30B 9/10; C30B 29/04; C30B 33/04**

(86) International application number:
**PCT/JP2022/019527**

(87) International publication number:
**WO 2022/264706 (22.12.2022 Gazette 2022/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.06.2021 JP 2021099431**

(71) Applicant: SUMITOMO ELECTRIC INDUSTRIES, LTD.
**Osaka-shi, Osaka 541-0041 (JP)**

(72) Inventors:
• **SUMIYA, Hitoshi**
  **Osaka-shi, Osaka 541-0041 (JP)**
• **LEE, Jin Hwa**
  **Osaka-shi, Osaka 541-0041 (JP)**
• **TERAMOTO, Minori**
  **Osaka-shi, Osaka 541-0041 (JP)**

(74) Representative: **Boult Wade Tennant LLP**
**Salisbury Square House**
**8 Salisbury Square**
**London EC4Y 8AP (GB)**

(54) **SYNTHETIC SINGLE CRYSTAL DIAMOND AND METHOD FOR PRODUCING SAME**

(57) A synthetic single crystal diamond that includes nitrogen atoms at a concentration of 50 ppm or more and 1000 ppm or less in terms of number of atoms, wherein the synthetic single crystal diamond contains an aggregate composed of one vacancy and two substitutional nitrogen atoms present adjacent to the vacancy, a ratio b/a of a length "b" of a longer diagonal line of a second Knoop indentation to a length "a" of a longer diagonal line of a first Knoop indentation is 0.90 or less on the synthetic single crystal diamond, the first Knoop indentation is an indentation formed on a surface of the synthetic single crystal diamond in a state where a Knoop indenter is pressed in a <110> direction of a {110} plane of the synthetic single crystal diamond in accordance with JIS Z 2251:2009 under conditions of a temperature of 23°C±5°C and a test load of 4.9 N, and the second Knoop indentation is a Knoop indentation remaining on the surface of the synthetic single crystal diamond after the test load is released.

FIG.1

**Description**

TECHNICAL FIELD

The present disclosure relates to a synthetic single crystal diamond and a method for manufacturing the same. The present application claims a priority based on Japanese Patent Application No. 2021-099431, filed on June 15, 2021. The content described in the Japanese Patent Application is entirely incorporated by reference herein.

BACKGROUND ART

Since single crystal diamonds are extremely hard, they are industrially used for: cutting tools such as a bit for precision cutting and processing and a cutter for woodworking; wear-resistant tools such as a dresser for grindstone, a die for delineation, a scribing tool, an orifice for water jet, and a wire guide; and other wide applications.

Many naturally produced single crystal diamonds (hereinafter, also referred to as "natural diamond") contain a nitrogen impurity as an aggregated impurity at a concentration of approximately several hundred to several thousand ppm (Ia type). The natural diamond has largely ununiform distribution of its impurity due to complex thermal history in generation inside the Earth, and has unevenness. In addition, the natural diamond contains many internal distortions and various crystal defects inside the crystal due to stress and various changes in heat applied during growth of the natural diamond. Thus, there is large variation of important mechanical characteristics for the tool, such as hardness and strength, even in the crystal. There is also large individual difference, and unstable quality and tool performance.

A part of the natural diamonds is a high-purity product that contains the nitrogen impurity at a concentration of several ppm or less (IIa type). However, such a natural diamond has many internal distortions and defects, and is unsuitable for the tool application.

As noted above, the natural diamond contains wide variety of internal distortions and structural defects, and the crystals are needed to be carefully selected for the industrial use. In addition, the natural diamond has large risks of change in cost and unstable supply.

On the other hand, synthetic single crystal diamonds artificially produced under high pressure at high temperature are synthesized under conditions of constant pressure and temperature, and thereby products with the same quality can be stably supplied. Therefore, the synthetic single crystal diamond is much superior to the natural diamond in industrial applications since it is smaller in variation of quality.

However, a nitrogen impurity is typically contained in the synthesized diamond at a concentration of about 100 ppm as isolated substitutional (dispersion-type) (Ib type), leading to deterioration of hardness and strength. Thus, use of such a synthetic diamond as the cutting tool tends to cause insufficient lifetime of the tool.

SUMMARY OF INVENTION

A synthetic single crystal diamond of the present disclosure is a synthetic single crystal diamond comprising nitrogen atoms at a concentration of 50 ppm or more and 1000 ppm or less in terms of number of atoms, wherein

the synthetic single crystal diamond contains an aggregate composed of one vacancy and two substitutional nitrogen atoms present adjacent to the vacancy,
a ratio b/a of a length "b" of a longer diagonal line of a second Knoop indentation to a length "a" of a longer diagonal line of a first Knoop indentation is 0.90 or less on the synthetic single crystal diamond,
the first Knoop indentation is an indentation formed on a surface of the synthetic single crystal diamond in a state where a Knoop indenter is pressed in a <110> direction of a {110} plane of the synthetic single crystal diamond in accordance with JIS Z 2251:2009 under conditions of a temperature of 23°C±5°C and a test load of 4.9 N, and
the second Knoop indentation is a Knoop indentation remaining on the surface of the synthetic single crystal diamond after the test load is released.

A method for manufacturing the synthetic single crystal diamond of the present disclosure is a method for manufacturing the above synthetic single crystal diamond, the method comprising:

a first step of synthesizing a diamond single crystal that contains nitrogen atoms at a concentration of 50 ppm or more and 1000 ppm or less in terms of number of atoms by a temperature-difference method that uses a solvent metal;
a second step of irradiating the diamond single crystal with one or both of electron beam and particle beam to apply energy of 10 MGy or more and 1000 MGy or less; and
a third step of performing heat treatment on the diamond single crystal after the second step in an inert gas at a pressure of 1 Pa or more and 100 KPa or less to obtain the synthetic single crystal diamond,

wherein a temperature "x" in the heat treatment in the third step is 1500°C or more and 1800°C or less, and a heating time "y" is 1 minute or more and 360 minutes or less.

BRIEF DESCRIPTION OF DRAWINGS

Fig. 1 is a view for describing a Knoop indentation.
Fig. 2 is a schematic sectional view that illustrates an example of constitution of a sample chamber used for manufacturing a synthetic single crystal diamond according to an embodiment of the present disclosure.

DETAILED DESCRIPTION

[Problem to be Solved by the Present Disclosure]

With the recent demand of longer lifetime of the tools, a synthetic single crystal diamond that has excellent breakage resistance has been required.

Accordingly, an object of the present disclosure is to provide the synthetic single crystal diamond that has excellent breakage resistance.

[Advantageous Effect of the Present Disclosure]

The synthetic single crystal diamond of the present disclosure has excellent breakage resistance.

[Description of Embodiments]

First, embodiments of the present disclosure will be listed and described.

(1) A synthetic single crystal diamond of the present disclosure is a synthetic single crystal diamond comprising nitrogen atoms at a concentration of 50 ppm or more and 1000 ppm or less in terms of number of atoms, wherein

the synthetic single crystal diamond contains an aggregate composed of one vacancy and two substitutional nitrogen atoms present adjacent to the vacancy,
a ratio b/a of a length "b" of a longer diagonal line of a second Knoop indentation to a length "a" of a longer diagonal line of a first Knoop indentation is 0.90 or less on the synthetic single crystal diamond,
the first Knoop indentation is an indentation formed on a surface of the synthetic single crystal diamond in a state where a Knoop indenter is pressed in a <110> direction of a {110} plane of the synthetic single crystal diamond in accordance with JIS Z 2251:2009 under conditions of a temperature of 23°C±5°C and a test load of 4.9 N, and
the second Knoop indentation is a Knoop indentation remaining on the surface of the synthetic single crystal diamond after the test load is released.

The synthetic single crystal diamond of the present disclosure has excellent breakage resistance.
(2) In a fluorescence spectrum obtained by irradiating the synthetic single crystal diamond with excitation light at a wavelength of 457 nm by using a fluorescence spectrophotometer, an emission peak is preferably present within one or both of a wavelength range of 503±2 nm and a wavelength range of 510 nm or more and 550 nm or less.
According to this, the synthetic single crystal diamond can have excellent breakage resistance.
(3) In an absorption spectrum of the synthetic single crystal diamond obtained by using an ultraviolet-visible light spectrophotometer, an absorption peak is preferably present within one or both of a wavelength range of 503±2 nm and a wavelength range of 470 nm or more and 500 nm or less.
According to this, the synthetic single crystal diamond can have excellent breakage resistance.
(4) In a fluorescence spectrum obtained by irradiating the synthetic single crystal diamond with excitation light at a wavelength of 830 nm by using a fluorescence spectrophotometer, an emission peak is preferably present within one or both of a wavelength range of 986±2 nm and a wavelength range of 1000 nm or more and 1300 nm or less.
According to this, the synthetic single crystal diamond can have excellent breakage resistance.
(5) In an absorption spectrum of the synthetic single crystal diamond obtained by using an ultraviolet-visible light spectrophotometer, an absorption peak is preferably present within one or both of a wavelength range of 986±2 nm and a wavelength range of 750 nm or more and 950 nm or less.

According to this, the synthetic single crystal diamond can have excellent breakage resistance.

(6) The synthetic single crystal diamond preferably contains no isolated substitutional nitrogen atom. According to this, the synthetic single crystal diamond can have excellent wear resistance and breakage resistance.

(7) A method for manufacturing the synthetic single crystal diamond of the present disclosure is a method for manufacturing the above synthetic single crystal diamond, the method comprising:

a first step of synthesizing a diamond single crystal that contains nitrogen atoms at a concentration of 50 ppm or more and 1000 ppm or less in terms of number of atoms by a temperature-difference method that uses a solvent metal;

a second step of irradiating the diamond single crystal with one or both of electron beam and particle beam to apply energy of 10 MGy or more and 1000 MGy or less; and

a third step of performing heat treatment on the diamond single crystal after the second step in an inert gas at a pressure of 1 Pa or more and 100 KPa or less to obtain the synthetic single crystal diamond,

wherein a temperature "x" in the heat treatment in the third step is 1500°C or more and 1800°C or less, and a heating time "y" is 1 minute or more and 360 minutes or less.

According to this, the synthetic single crystal diamond that has excellent breakage resistance can be obtained.

(8) The temperature "x"°C and the heating time "y" minutes in the third step preferably satisfy the following Formula 1,

$$-0.097x + 175 \leq y \leq -1.1x + 2030 \qquad \text{Formula 1.}$$

According to this, the synthetic single crystal diamond can have excellent breakage resistance.

[Detailed Description of Embodiments]

A specific example of the synthetic single crystal diamond of the present disclosure will be described hereinafter with reference to the drawings. In the drawings of the present disclosure, a same reference sign represents same parts or corresponding parts. A size relationship of length, width, thickness, depth, and the like are appropriately modified for clarify and simplify the drawings, and not necessarily illustrates an actual size relationship.

The description form "A to B" herein means an upper limit and lower limit of the range (that is, A or more and B or less). When there is not description on a unit of A and only a unit of B is described, the unit of A and the unit of B are same.

Herein, a generic plane orientation that includes crystallogeometrically equivalent plane orientations is represented by {}, and a generic direction that includes crystallogeometrically equivalent directions is represented by <>.

When one or more values are each described in the present disclosure as lower limits and upper limits of numerical ranges, combinations of any one value described as a lower limit and any one value described as an upper limit are also described. For example, when a1 or more, b1 or more, and c1 or more are described as lower limits, and when a2 or less, b2 or less, and c2 or less are described as upper limits, disclosed are a1 or more and a2 or less, a1 or more and b2 or less, a1 or more and c2 or less, b1 or more and a2 or less, b1 or more and b2 or less, b1 or more and c2 or less, c1 or more and a2 or less, c1 or more and b2 or less, and c1 or more and c2 or less.

<Existence Form of Nitrogen Atoms in Diamond Crystal>

To deepen understanding of the synthetic single crystal diamond of the present embodiment, nitrogen atoms that are present as an impurity in the crystal, which are one of major factors to determine characteristics of diamond, will be firstly described.

Nitrogen atoms in the diamond crystal can be classified into an isolated substitutional nitrogen atom, an aggregation-type nitrogen atom, and the like according to their existence form.

The isolated substitutional nitrogen atom (C center) is a nitrogen atom present at a position of a carbon atom in the diamond crystal by substitution in one atomic unit.

A synthetic single crystal diamond that contains the isolated substitutional nitrogen atom exhibits an absorption peak near a wavenumber of 1130 $cm^{-1}$ (that is, wavenumber of $1130\pm2$ $cm^{-1}$) in an infrared absorption spectrum measured by Fourier-transform infrared spectrometry. The wavenumber of $1130\pm2$ $cm^{-1}$ means a wavenumber of 1128 $cm^{-1}$ or more and 1132 $cm^{-1}$ or less.

In the synthetic single crystal diamond that contains the isolated substitutional nitrogen atoms, a lone-pair electron derived from the nitrogen atom is present, and a concentration of the isolated substitutional nitrogen atoms can be measured by electron spin resonance (ESR) analysis. The ESR also detects a signal of not only the isolated substitutional nitrogen atoms but also crystal defects that have a lone-pair electron, and the like. In this case, the isolated substitutional nitrogen atoms can be separately detected with g-value or a relaxation time of the signal.

The aggregation-type nitrogen atoms are two or more nitrogen atoms present with aggregation in the diamond crystal.

The aggregation-type nitrogen atoms are present in an A center (nitrogen atom pair), an H3 center and an H2 center (aggregation of two nitrogen atoms and a vacancy), an N3 center (aggregation of three nitrogen atoms), a B center (condensation of four nitrogen atoms), a B' center, a platelet, and the like.

The A center (nitrogen atom pair) is an aggregate composed of two nitrogen atoms, and the two nitrogen atoms are covalently bonded, and carbon atoms that constitute the diamond crystal are substituted with the respective nitrogen atoms. A diamond that contains the A center (nitrogen atom pair) is called IaA type. A synthetic single crystal diamond that contains the A center (nitrogen atom pair) exhibits an absorption peak near a wavenumber of 1282 $cm^{-1}$ (for example, a wavenumber of 1282$\pm$2 $cm^{-1}$) in an infrared absorption spectrum measured by Fourier-transform infrared spectrometry. The wavenumber of 1282$\pm$2 $cm^{-1}$ means a wavenumber of 1280 $cm^{-1}$ or more and 1284 $cm^{-1}$ or less.

The H3 center and the H2 center (aggregation of two nitrogen atoms and a vacancy) is an aggregate composed of one vacancy and two nitrogen atoms present adjacent to the vacancy, and carbon atoms that constitute the diamond crystal are substituted with the respective nitrogen atoms. An electric charge of the H3 center is neutral, and the H2 center has a negative electric charge. Herein, "nitrogen atom present adjacent to a vacancy" means a nitrogen atom positioned in the shortest interatomic distance with a carbon atom hypothetically present in a position of the vacancy (that is, "nearest neighbor"). The same applies to the N3 center and the B center, described later.

As for a synthetic single crystal diamond that contains the H3 center, an emission peak is present within one or both of a wavelength range of 503$\pm$2 nm and a wavelength range of 510 nm or more and 550 nm or less in a fluorescence spectrum obtained by irradiating the synthetic single crystal diamond with excitation light at a wavelength of 457 nm by using a fluorescence spectrophotometer. Here, the emission peak within the range of the wavelength of 503$\pm$2 nm is an emission peak that corresponds to a zero-phonon line of the H3 center. The emission peak within the range of the wavelength of 510 nm or more and 550 nm or less is an emission peak that corresponds to a sub-band (phonon-side band) of the H3 center. The emission peak within the range of the wavelength of 500 nm or more and 550 nm or less may be observed as one or more mountain-shaped peaks within this range. The wavelength of 503$\pm$2 nm means a wavelength of 501 nm or more and 505 nm or less.

As for the synthetic single crystal diamond that contains the H3 center, an absorption peak is present within one or both of a wavelength range of 503$\pm$2 nm and a wavelength range of 470 nm or more and 500 nm or less in an absorption spectrum of the synthetic single crystal diamond obtained by using an ultraviolet-visible light spectrophotometer. Here, the absorption peak within the range of the wavelength of 503$\pm$2 nm is an absorption peak that corresponds to a zero-phonon line of the H3 center, and the absorption peak within the range of the wavelength of 470 nm or more and 500 nm or less is an absorption peak that corresponds to a sub-band (phonon-side band) of the H3 center. The absorption peak within the range of the wavelength of 470 nm or more and 500 nm or less may be observed as one or more mountain-shaped peaks within this range. The wavelength of 503$\pm$2 nm means a wavelength of 501 nm or more and 505 nm or less.

As for a synthetic single crystal diamond that contains the H2 center, an emission peak is present within one or both of a wavelength range of 986$\pm$2 nm and a wavelength range of 1000 nm or more and 1300 nm or less in a fluorescence spectrum obtained by irradiating the synthetic single crystal diamond with excitation light at a wavelength of 830 nm by using a fluorescence spectrophotometer. Here, the emission peak within the range of the wavelength of 986$\pm$2 nm is an emission peak that corresponds to a zero-phonon line of the H2 center, and the emission peak within the range of the wavelength of 1000 nm or more and 1300 nm or less is an emission peak that corresponds to a sub-band (phonon-side band) of the H2 center. The emission peak within the range of the wavelength of 1000 nm or more and 1300 nm or less may be observed as one or more mountain-shaped peaks within this range. The wavelength of 986$\pm$2 nm means a wavelength of 984 nm or more and 988 nm or less.

As for the synthetic single crystal diamond that contains the H2 center, an absorption peak is present within one or both of a wavelength range of 986$\pm$2 nm and a wavelength range of 750 nm or more and 950 nm or less in an absorption spectrum of the synthetic single crystal diamond obtained by using an ultraviolet-visible light spectrophotometer. Here, the absorption peak within the range of the wavelength of 986$\pm$2 nm is an absorption peak that corresponds to a zero-phonon line of the H2 center, and the absorption peak within the range of the wavelength of 750 nm or more and 950 nm or less is an absorption peak that corresponds to a sub-band (phonon-side band) of the H2 center. The absorption peak within the range of the wavelength of 750 nm or more and 950 nm or less may be observed as one or more mountain-shaped peaks within this range. The wavelength of 986$\pm$2 nm means a wavelength of 984 nm or more and 988 nm or less.

The optical measurements for obtaining the above fluorescence spectrum and absorption spectrum are performed at room temperature (23°C ±5°C, namely 18°C or more and 28°C or less). When the peak position is difficult to determine with the fluorescence spectrum and/or absorption spectrum obtained at the room temperature, the optical measurements are performed at a liquid-nitrogen temperature 77 K.

The N3 center (aggregation of three nitrogen atoms and a vacancy) is an aggregate composed of one vacancy and three nitrogen atoms present adjacent to the vacancy, and carbon atoms that constitute the diamond crystal are substituted with the respective nitrogen atoms.

A synthetic single crystal diamond that contains the N3 center (aggregation of three nitrogen atoms and a vacancy) exhibits an emission peak within one or both of a fluorescent wavelength range of near 415 nm (for example, a fluorescent wavelength of 415±2 nm) and a fluorescent wavelength range of 420 nm or more and 470 nm or less in a fluorescence spectrum obtained by irradiating the synthetic single crystal diamond with excitation light at a wavelength of shorter than approximately 410 nm, for example a wavelength of 325 nm. The fluorescent wavelength 415±2 nm means a fluorescent wavelength of 409 nm or more and 417 nm or less.

The B center (aggregation of four nitrogen atoms and a vacancy) is an aggregate composed of one vacancy and four nitrogen atoms present adjacent to the vacancy, and carbon atoms that constitute the diamond crystal are substituted with the respective nitrogen atoms.

A diamond that contains the B center (aggregation of four nitrogen atoms and a vacancy) is called IaB type. The synthetic single crystal diamond that contains the B center exhibits an absorption peak of a wavenumber of near 1175 $cm^{-1}$ (for example, a wavenumber of 1175±2 $cm^{-1}$) in an infrared absorption spectrum measured by Fourier-transform infrared spectrometry. The wavenumber 1175±2 $cm^{-1}$ means a wavenumber of 1173 $cm^{-1}$ or more and 1177 $cm^{-1}$ or less.

The B' center (also called platelet) is a plate-shaped aggregate composed of five or more nitrogen atoms and an interlattice carbon, and incorporated as an inclusion in the crystal.

A diamond that contains the B' center (platelet) is called IaB' type. The synthetic single crystal diamond that contains the B' center (platelet) exhibits an absorption peak at a wavenumber of 1358 $cm^{-1}$ or more and 1385 $cm^{-1}$ or less in the infrared absorption spectrum measured by Fourier-transform infrared spectrometry.

The above aggregates are contained in natural diamonds, and hardly contained in conventional synthetic single crystal diamonds in typical.

The present inventors have novelly found that the H3 center and/or the H2 center among the above aggregates are easily formed in the synthetic single crystal diamond and that the synthetic single crystal diamond that contains the H3 center and/or the H2 center has a few crystal distortions and stable structure. The present inventors have then novelly found that mechanical characteristics of the synthetic single crystal diamond, such as hardness, strength, wear resistance, and breakage resistance, can be improved at a low cost by advantageously forming the H3 center and/or the H2 center in the synthetic single crystal diamond. These findings have led to complete the present disclosure.

[Embodiment 1: Synthetic Single Crystal Diamond]

A synthetic single crystal diamond of the present embodiment is a synthetic single crystal diamond comprising nitrogen atoms at a concentration of 50 ppm or more and 1000 ppm or less in terms of number of atoms, wherein

the synthetic single crystal diamond contains an aggregate composed of one vacancy and two substitutional nitrogen atoms present adjacent to the vacancy,
a ratio b/a of a length "b" of a longer diagonal line of a second Knoop indentation to a length "a" of a longer diagonal line of a first Knoop indentation is 0.90 or less on the synthetic single crystal diamond,
the first Knoop indentation is an indentation formed on a surface of the synthetic single crystal diamond in a state where a Knoop indenter is pressed in a <110> direction of a {110} plane of the synthetic single crystal diamond in accordance with JIS Z 2251:2009 under conditions of a temperature of 23°C±5°C and a test load of 4.9 N, and
the second Knoop indentation is a Knoop indentation remaining on the surface of the synthetic single crystal diamond after the test load is released.

The synthetic single crystal diamond of the present embodiment can have excellent breakage resistance. Furthermore, the synthetic single crystal diamond of the present embodiment can also have excellent wear resistance. The reason is unclear, but presumed as the following (i) to (iii).

(i) The synthetic single crystal diamond of the present embodiment contains nitrogen atoms at a concentration of 50 ppm or more and 1000 ppm or less in terms of number of atoms. According to this, the nitrogen atoms in the synthetic single crystal diamond easily aggregate each other. Thus, an aggregate that contains the nitrogen atoms is easily present in this synthetic single crystal diamond, and wear resistance and breakage resistance of this synthetic single crystal diamond are improved.

(ii) The synthetic single crystal diamond of the present embodiment contains the aggregate composed of one vacancy and two substitutional nitrogen atoms present adjacent to the vacancy. That is, the synthetic single crystal diamond of the present embodiment contains the H3 center and/or the H2 center. The H3 center and/or the H2 center present in the synthetic single crystal diamond improve mechanical characteristics of the synthetic single crystal diamond, such as hardness, strength, wear resistance, and breakage resistance.

Furthermore, the H3 center and/or the H2 center inhibit generation of cracking and plastic deformation that occur when a load is applied to the synthetic single crystal diamond. If these cracking and plastic deformation locally occur, their development is inhibited by the H3 center and/or the H2 center, which does not lead breakage of the synthetic single crystal diamond. As above, the synthetic single crystal diamond that contains the H3 center and/or the H2 center has improved breaking strength and elastic deformability, and improved breakage resistance.

(iii) In the synthetic single crystal diamond of the present embodiment, the ratio b/a of the length "b" of a longer diagonal line of the second Knoop indentation to the length "a" of a longer diagonal line of the first Knoop indentation is 0.90 or less. This synthetic single crystal diamond has excellent toughness and breakage resistance.

<Nitrogen-Atom Concentration>

The synthetic single crystal diamond of the present embodiment contains nitrogen atoms at a concentration of 50 ppm or more and 1000 ppm or less in terms of number of atoms (hereinafter, the concentration of nitrogen atoms in terms of number of atoms is also referred to as "nitrogen-atom concentration"). When the nitrogen-atom concentration is 50 ppm or more, the nitrogen atoms in the synthetic single crystal diamond easily form the aggregate that contains the nitrogen atoms. When the nitrogen-atom concentration is 1000 ppm or less, the synthetic single crystal diamond can have excellent wear resistance and breakage resistance.

A lower limit of the nitrogen-atom concentration in the synthetic single crystal diamond is preferably 100 ppm or more, preferably 150 ppm or more, preferably 200 ppm or more, preferably 250 ppm or more, and preferably 300 ppm or more. An upper limit of the nitrogen-atom concentration in the synthetic single crystal diamond is preferably 900 ppm or less, preferably 850 ppm or less, and preferably 800 ppm or less. The nitrogen-atom concentration in the synthetic single crystal diamond is preferably 50 ppm or more and 900 ppm or less, preferably 50 ppm or more and 850 ppm or less, preferably 100 ppm or more and 1000 ppm or less, preferably 100 ppm or more and 900 ppm or less, preferably 100 ppm or more and 850 ppm or less, preferably 150 ppm or more and 1000 ppm or less, preferably 150 ppm or more and 900 ppm or less, preferably 150 ppm or more and 850 ppm or less, preferably 250 ppm or more and 1000 ppm or less, preferably 250 ppm or more and 900 ppm or less, and preferably 250 ppm or more and 850 ppm or less.

The nitrogen-atom concentration in the synthetic single crystal diamond can be measured by secondary ion mass spectrometry (SIMS).

As long as an identical sample is measured, a plurality of times of the measurement with changing a selected position of the measurement region yields little variation of the measurement results, and it has been confirmed that randomly setting the measurement regions does not become arbitrary.

<Aggregation-Type Nitrogen Atom>

The synthetic single crystal diamond of the present embodiment contains the aggregate composed of one vacancy and two substitutional nitrogen atoms present adjacent to the vacancy. That is, the synthetic single crystal diamond of the present embodiment contains the H3 center and/or the H2 center. The H3 center and/or the H2 center present in the synthetic single crystal diamond improve mechanical characteristics of the synthetic single crystal diamond, such as hardness, strength, wear resistance, and breakage resistance.

Furthermore, the H3 center and/or the H2 center inhibit generation of cracking and plastic deformation that occur when a load is applied to the synthetic single crystal diamond. If these cracking and plastic deformation locally occur, their development is inhibited by the H3 center and/or the H2 center, which does not lead breakage of the synthetic single crystal diamond. As above, the synthetic single crystal diamond that contains the H3 center and/or the H2 center has improved breaking strength and elastic deformability, and improved breakage resistance.

The H3 center and/or the H2 center contained in the synthetic single crystal diamond can be confirmed by a fluorescence spectrum obtained by using a fluorescence spectrophotometer and/or by an absorption spectrum obtained by using an ultraviolet-visible light spectrophotometer.

When an emission peak is present within one or both of a wavelength range of $503\pm2$ nm and a wavelength range of 510 nm or more and 550 nm or less in a fluorescence spectrum (horizontal axis: wavelength (nm), vertical axis: fluorescent intensity or emission intensity) obtained by irradiating the synthetic single crystal diamond with excitation light at a wavelength of 457 nm by using a fluorescence spectrophotometer, the synthetic single crystal diamond is judged to contain the H3 center. The wavelength of $503\pm2$ nm means a wavelength of 501 nm or more and 505 nm or less. The emission peak present within the range of the wavelength of $503\pm2$ nm means that the maximum value of the peak is present within the above range. The emission peak present within the range of the wavelength of 510 nm or more and 550 nm or less means that the maximum value of the peak is present within the above range.

When an absorption peak is present within one or both of a wavelength range of $503\pm2$ nm and a wavelength range of 470 nm or more and 500 nm or less in an absorption spectrum (horizontal axis: wavelength (nm), vertical axis: absorbance or absorption coefficient) of the synthetic single crystal diamond obtained by using an ultraviolet-visible light spectrophotometer, the synthetic single crystal diamond is judged to contain the H3 center. The wavelength of $503\pm2$ nm means a wavelength of 501 nm or more and 505 nm or less. The absorption peak present within the range of the wavelength of $503\pm2$ nm means that the maximum value of the peak is present within the above range. The absorption peak present within the range of the wavelength of 470 nm or more and 500 nm or less means that the maximum value of the peak is present within the above range.

When the synthetic single crystal diamond contains the H3 center, both of the emission peak in the above fluorescence spectrum and the absorption peak in the above absorption spectrum are typically present. On the other hand, when any one of the emission peak and the absorption peak is extremely small and difficult to confirm the presence of the extremely small peak and only any one of the emission peak and the absorption peak is observed, the synthetic single crystal diamond is also judged to contain the H3 center.

When an emission peak is present within one or both of a wavelength range of $986\pm2$ nm and a wavelength range of 1000 nm or more and 1300 nm or less in a fluorescence spectrum (horizontal axis: wavelength (nm), vertical axis: fluorescent intensity or emission intensity) obtained by irradiating the synthetic single crystal diamond with excitation light at a wavelength of 830 nm by using a fluorescence spectrophotometer, the synthetic single crystal diamond is judged to contain the H2 center. The wavelength of $986\pm2$ nm means a wavelength of 984 nm or more and 988 nm or less. The emission peak present within the range of the wavelength of $986\pm2$ nm means that the maximum value of the peak is present within the above range. The emission peak present within the range of the wavelength of 1000 nm or more and 1300 nm or less means that the maximum value of the peak is present within the above range.

When an absorption peak is present within one or both of a wavelength range of $986\pm2$ nm and a wavelength range of 750 nm or more and 950 nm or less in an absorption spectrum (horizontal axis: wavelength (nm), vertical axis: absorbance or absorption coefficient) of the synthetic single crystal diamond obtained by using an ultraviolet-visible light spectrophotometer, the synthetic single crystal diamond is judged to contain the H2 center. The wavelength of $986\pm2$ nm means a wavelength of 984 nm or more and 988 nm or less. The absorption peak present within the range of the wavelength of $986\pm2$ nm means that the maximum value of the peak is present within the above range. The absorption peak present within the range of the wavelength of 750 nm or more and 950 nm or less means that the maximum value of the peak is present within the above range.

When the synthetic single crystal diamond contains the H2 center, both of the emission peak in the above fluorescence spectrum and the absorption peak in the above absorption spectrum are typically present. On the other hand, when any one of the emission peak and the absorption peak is extremely small and difficult to confirm the presence of the extremely small peak and only any one of the emission peak and the absorption peak is observed, the synthetic single crystal diamond is also judged to contain the H2 center.

<Isolated Substitutional Nitrogen Atom>

The synthetic single crystal diamond of the present embodiment preferably contains no isolated substitutional nitrogen atom. The present inventors have novelly found that an isolated substitutional nitrogen atom contained in the diamond crystal generates local tensile stress in crystal lattices around the nitrogen atom, which triggers plastic deformation and breakage to deteriorate hardness, wear resistance, and breakage resistance. Based on this finding, the present inventors have found that no isolated substitutional nitrogen atom contained in the diamond crystal is preferable from the viewpoint of improvement of wear resistance and breakage resistance.

The synthetic single crystal diamond that contains no isolated substitutional nitrogen atom can be confirmed by an infrared absorption spectrum measured by Fourier-transform infrared spectrometry. Specifically, when an absorption peak is absent within a range of a wavenumber of $1130\pm2$ $cm^{-1}$ in the infrared absorption spectrum, the synthetic single crystal diamond is judged to contain no isolated substitutional nitrogen atom. The wavenumber of $1130\pm2$ $cm^{-1}$ means a wavenumber of 1128 $cm^{-1}$ or more and 1132 $cm^{-1}$ or less.

When a shoulder is present within the range of the wavenumber of $1130\pm2$ $cm^{-1}$ in the infrared absorption spectrum and whether this shoulder is the absorption peak derived from the isolated substitutional nitrogen atom is unclear, the presence or absence of the isolated substitutional nitrogen atom can be judged by ESR analysis. When the isolated substitutional nitrogen atom is absent in the synthetic single crystal diamond, a lone-pair electron is absent in the single crystal diamond. Therefore, no signal is detected by ESR analysis on such a single crystal diamond. According to this, the absence of the isolated substitutional nitrogen atom in the synthetic single crystal diamond can be confirmed.

<Ratio b/a of Second Knoop Indentation "b" to First Knoop Indentation "a">

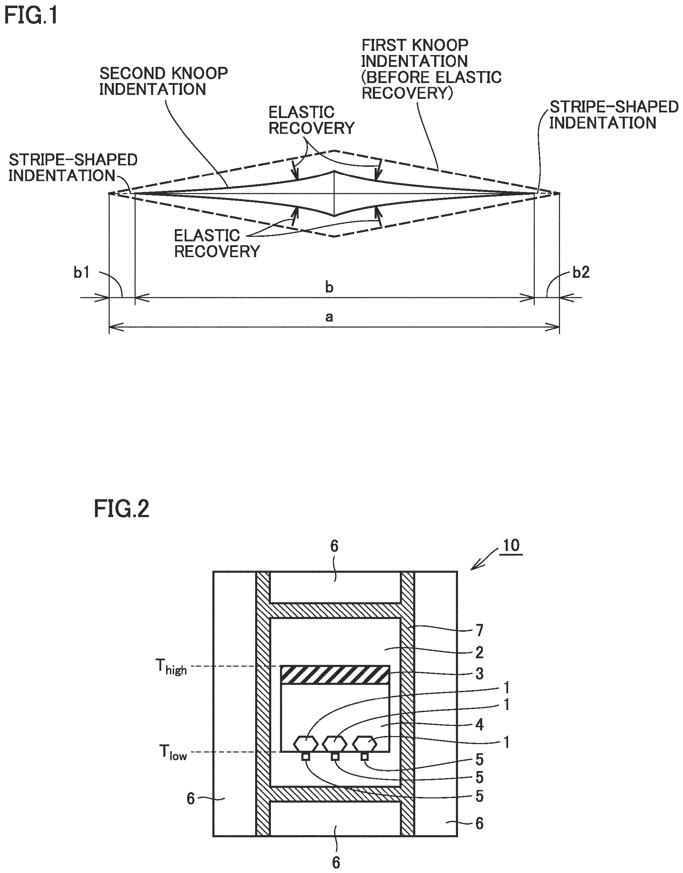

On the synthetic single crystal diamond of the present embodiment, a ratio b/a of a length "b" of a longer diagonal line of a second Knoop indentation to a length "a" of a longer diagonal line of a first Knoop indentation is 0.90 or less. The crystal diamond in a state where a Knoop indenter is pressed in a <110> direction of a {110} plane of the synthetic single crystal diamond in accordance with JIS Z 2251:2009 under conditions of a temperature of 23°C±5°C and a test load of 4.9 N, and is a contacting interface between the Knoop indenter and the synthetic single crystal diamond. The second Knoop indentation is a Knoop indentation remaining on the surface of the synthetic single crystal diamond after the test load is released. The second Knoop indentation has, for example, a rhombus shape with inward curved sides, as illustrated in Fig. 1. Hereinafter, the ratio b/a of the length "b" of a longer diagonal line of the second Knoop indentation to the length "a" of a longer diagonal line of the first Knoop indentation is also referred to as "{110}<110>b/a". As a tester used for measuring the first Knoop indentation and the second Knoop indentation, a micro-Vickers hardness tester HM (Mitsutoyo HM), manufactured by Mitsutoyo Corporation, can be used, for example. Since the first Knoop indentation may be difficult to measure with an optical microscope attached to the tester, the first Knoop indentation is desirably measured with an image with a laser microscope or a scanning microscope with a magnification of 3000 to 10000.

The Knoop hardness test prescribed in JIS Z 2251:2009 is known as one method for measuring a hardness of an industrial material. With the Knoop hardness test, a hardness of a material to be measured is determined by pressing the material to be measured with a Knoop indenter at a predetermined temperature and a predetermined load (test load). In the present embodiment, the predetermined temperature is 23°C±5°C (that is, 18°C or more and 28°C or less), and the predetermined load is 4.9 N.

The Knoop indenter refers to an indenter that has a quadrangular pyramidal shape with a rhombus bottom, and made of diamond. In the Knoop hardness test, a top side, which is opposite side to the bottom, of the Knoop indenter is pressed against the material to be measured. The Knoop indentation herein is defined as meanings that encompass: the first Knoop indentation that is a rhombus trace (see "FIRST KNOOP INDENTATION" in Fig. 1) formed on a surface of the material to be measured (in the present embodiment, the synthetic single crystal diamond) in a state where the Knoop indenter is pressed against the surface of the material to be measured under the conditions of the temperature of 23°C±5°C and the test load of 4.9 N; and the second Knoop indentation that is a permanently deformed trace (see "SECOND KNOOP INDENTATION" in Fig. 1) remaining on the surface of the material to be measured immediately after the test load is released.

With a perfect plastic material, such as a typical metal material, the first Knoop indentation in a state of pressing the Knoop indenter and the second Knoop indentation remaining after the Knoop indenter is removed have the same shape. The Knoop indentation has the same shape before and after the release of the test load, and is, for example, a rhombus shape illustrated with a broken line as "FIRST KNOOP INDENTATION" in Fig. 1. Therefore, with the perfect plastic material, the length "a" of a longer diagonal line of the first Knoop indentation (see Fig. 1) and the length "b" of a longer diagonal line of the second Knoop indentation (see Fig. 1) are equal (a=b).

On the other hand, when the material to be measured is an elastic material, removal of the indenter to release the test load generates elastic recovery in the Knoop indentation in a direction with an arrow that indicates the elastic recovery in Fig. 1. The Knoop indentation attempts to return to be original, and reaches a permanently deformed trace (elastic recovery). In this case, the "a" and the "b" exhibit a relationship of a>b.

A large return in the direction with the arrow that indicates the elastic recovery in Fig. 1 reduces the ratio b/a of the "b" to the "a". That is, a smaller value of the ratio b/a indicates larger elastic recovery (elastic property).

Since a conventional common single crystal diamond has extremely low elasticity, the "a" and the "b" are the same length (a=b). On the other hand, the synthetic single crystal diamond of the present embodiment, which exhibits the ratio b/a of the "b" to the "a" of 0.90 or less, has large elasticity, and thereby cracking occurrence resistance against a tensile stress is improved. Thus, when used for a material of a tool, the synthetic single crystal diamond relaxes stress concentration at the edge to inhibit damage due to breakage of the edge.

Furthermore, when the synthetic single crystal diamond of the present embodiment is used for cutting that requires ultraprecision, the edge is elastically deformed, and thereby a diffraction phenomenon (so-called iridescent pattern) to cause a problem such as in mirror-surface processing due to the cutting trace hardly occurs.

On the synthetic single crystal diamond according to the present embodiment, the ratio b/a of the "b" to the "a" is 0.90 or less. When the value of the ratio (b/a) exceeds 0.90, brittleness becomes high, and cracking easily occurs when a local stress is applied.

An upper limit of the ratio (b/a) is 0.90 or less, preferably 0.888 or less, preferably 0.88 or less, more preferably 0.86 or less, and further preferably 0.84 or less from the viewpoint of improvement of the breakage resistance. A lower limit of the ratio b/a is preferably 0.66 or more or 0.70 or more from the viewpoint of inhibition of processability deterioration due to deformation of the edge during the processing. The ratio b/a is preferably 0.66 or more and 0.90 or less, preferably 0.70 or more and 0.90 or less, more preferably 0.72 or more and 0.88 or less, and further preferably 0.74 or more and 0.86 or less.

The length "a" of a longer diagonal line of the first Knoop indentation and the length "b" of a longer diagonal line of the second Knoop indentation herein are measured by the following method.

A Knoop indenter is pressed against the material to be measured (synthetic single crystal diamond) in the <110> direction of the {110} plane in accordance with the Knoop hardness test performed under conditions prescribed in JIS Z 2251:2009 at a temperature of 23°C±5°C and a test load of 4.9 N. Thereafter, the test load is released and then the permanently deformed second Knoop indentation formed on the surface of the synthetic single crystal diamond is observed with an optical microscope attached to a common microhardness tester or observed with a laser microscope to measure the length "b" of a longer diagonal line of the second Knoop indentation.

Furthermore, the surface of the synthetic single crystal diamond after the test load is released is precisely observed with a high-resolution scanning electron microscope (for example, a field emission scanning electron microscope (FE-SEM)) or a highly sensitive differential interference contrast microscope (a microscope to impart an interference color contrast with polarization interference to achieve visualization).

When the surface of the synthetic single crystal diamond is observed with the high-resolution scanning electron microscope or the highly sensitive differential interference contrast microscope, an extremely small stripe-shaped indentation that is not observed with a common optical microscope is observed from a top of the permanently deformed second Knoop indentation toward an outside of the second Knoop indentation, as illustrated in Fig. 1.

The length "b" of a longer diagonal line of the second Knoop indentation, a length "b1" of the stripe-shaped indentation continued to a first end of one longer diagonal line, and a length "b2" of the stripe-shaped indentation continued to a second end that is an opposite side of the first end are measured. A total of the length "b" of the longer diagonal line and the lengths "b1" and "b2" of the stripe-shaped indentations (b+b1+b2) is specified as the length "a" of a longer diagonal line of the first Knoop indentation.

As long as an identical sample is measured, a plurality of times of the measurement with changing a selected position of the measurement region yields little variation of the measurement results, and it has been confirmed that randomly setting the measurement regions does not become arbitrary.

[Embodiment 2: Method for Manufacturing Synthetic Single Crystal Diamond]

An example of a method for manufacturing the synthetic single crystal diamond of Embodiment 1 will be described hereinafter.

The method for manufacturing the synthetic single crystal diamond of the present embodiment is a method for manufacturing the synthetic single crystal diamond of Embodiment 1, the method comprising:

a first step of synthesizing a diamond single crystal that contains nitrogen atoms at a concentration of 50 ppm or more and 1000 ppm or less in terms of number of atoms by a temperature-difference method that uses a solvent metal;
a second step of irradiating the diamond single crystal with one or both of electron beam and particle beam to apply energy of 10 MGy or more and 1000 MGy or less; and
a third step of performing heat treatment on the diamond single crystal after the second step in an inert gas at a pressure of 1 Pa or more and 100 KPa or less to obtain the synthetic single crystal diamond,
wherein a temperature "x" in the heat treatment in the third step is 1500°C or more and 1800°C or less, and a heating time "y" is 1 minute or more and 360 minutes or less.

(First Step)

The diamond single crystal can be produced by the temperature-difference method by using a sample chamber that has constitution illustrated in Fig. 2, for example.

As illustrated in Fig. 2, in a sample chamber 10 used for manufacturing a diamond single crystal 1, an insulator 2, a carbon source 3, a solvent metal 4, and a seed crystal 5 are disposed in a space surrounded by a graphite heater 7, and a pressure medium 6 is disposed outside graphite heater 7. The temperature-difference method is a synthesis method in which a temperature gradient is provided inside sample chamber 10 in a vertical direction, carbon source 3 is disposed in a high-temperature portion (T high), seed crystal 5 of diamond is disposed in a low-temperature portion (T low), solvent metal 4 is interposed between carbon source 3 and seed crystal 5, and diamond single crystal 1 is grown on seed crystal 5 by holding conditions of a temperature equal to or higher than a temperature at which this solvent metal 4 is melted and a pressure equal to or higher than a pressure at which diamond is thermally stable. For example, the pressure in the sample chamber is regulated within a range of 5.0 to 6.0 GPa, the temperature of the low-temperature portion is regulated within a range of 1360°C to 1380°C, and such conditions are held for 50 to 200 hours to grow the diamond single crystal on the seed crystal.

As carbon source 3, a diamond powder is preferably used. Graphite and pyrolyzed carbon can also be used.

As solvent metal 4, one or more metals selected from iron (Fe), cobalt (Co), nickel (Ni), manganese (Mn), and the like, or an alloy that contains these metals can be used.

Into carbon source 3 and solvent metal 4, nitrides such as iron nitride ($Fe_2N$ and $Fe_3N$), aluminum nitride (AlN), phosphorus nitride ($P_3N_4$), and silicon nitride ($Si_3N_4$), and organic nitrogen compounds such as melamine and sodium azide can be added as a single substance or a mixture as a nitrogen supply source, for example. As the nitrogen supply source, diamond or graphite that contains a large amount of nitrogen may also be added. This addition enables the diamond single crystal to be synthesized to contain nitrogen atoms. In this time, the nitrogen atoms in the diamond single crystal are present mainly as the isolated substitutional nitrogen atoms.

A content of the nitrogen supply source in carbon source 3 or solvent metal 4 is regulated so that the concentration of the nitrogen atoms in the diamond single crystal to be synthesized is 50 ppm or more and 1000 ppm or less. For example, with the carbon source, the content of the nitrogen atoms derived from the nitrogen supply source can be set to 200 ppm or more and 3000 ppm or less. With the solvent metal, the content of the nitrogen supply source can be set to, for example, 0.01 mass% or more and 0.2 mass% or less when the metal solvent is an alloy composed of iron-cobalt-nickel and the nitrogen supply source is $Fe_3N$.

Solvent metal 4 may further contain one or more elements selected from the group consisting of titanium (Ti), vanadium (V), chromium (Cr), manganese (Mn), copper (Cu), zirconium (Zr), niobium (Nb), molybdenum (Mo), ruthenium (Ru), rhodium (Rh), hafnium (Hf), tantalum (Ta), tungsten (W), Osmium (Os), Iridium (Ir), and platinum (Pt).

(Second Step)

Then, the obtained diamond single crystal is irradiated with any one or both of electron beam and particle beam to apply energy of 10 MGy or more and 1000 MGy or less. This irradiation introduces lattice defects in the diamond single crystal to form vacancies.

If an amount of the irradiation energy is less than 10 MGy, the introduction of the lattice defects may be insufficient. On the other hand, if the energy amount exceeds 1000 MGy, excessive vacancies may be generated to considerably deteriorate crystallinity. Therefore, the energy amount is preferably 10 MGy or more and 1000 MGy or less.

As the particle beam, neutron beam or proton beam can be used. Irradiation conditions are not particularly limited as long as the energy of 10 MGy or more and 1000 MGy or less can be applied to the diamond single crystal. For example, when electron beam is used, an irradiation energy can be 4.6 MeV or more and 4.8 MeV or less, a current can be 2 mA or more and 5 mA or less, and an irradiation time can be 30 hours or more and 45 hours or less.

(Third Step)

Then, the heat treatment is performed on the diamond single crystal after the second step in an inert gas at a pressure of 1 Pa or more and 100 KPa or less to obtain the synthetic single crystal diamond. The temperature "x" in the heat treatment in the third step is 1500°C or more and 1800°C or less, and the heating time "y" is 1 minute or more and 360 minutes or less. By the heat treatment in the third step, the isolated substitutional nitrogen atoms in the diamond single crystal move through the vacancies to aggregate, and form the aggregation-type nitrogen atoms. The term "in the inert gas" herein means "in an inert gas atmosphere such as nitrogen and argon gas".

When the temperature "x" in the heat treatment in the third step is 1500°C or more, the move of the nitrogen atoms in the diamond single crystal is promoted, and formation of the aggregate composed of one vacancy and two substitutional nitrogen atoms present adjacent to the vacancy (the H3 center or the H2 center) is promoted. If the temperature in the third step is less than 1500°C, the H3 center or the H2 center is difficult to form. An upper limit of the temperature "x" is 1800°C or less from the viewpoint of prevention of a decrease in these color centers or graphitization of the diamond.

When the heating time "y" of the heat treatment in the third step is 1 minute or more, the move of the nitrogen atoms in the diamond single crystal is promoted, and formation of the aggregate composed of one vacancy and two substitutional nitrogen atoms present adjacent to the vacancy (the H3 center and/or the H2 center) is promoted. An upper limit of the heating time "y" is 360 minutes or less from the viewpoint of prevention of a decrease in these color centers or graphitization of the diamond.

The temperature "x"°C and the heating time "y" minutes in the third step preferably satisfy the following Formula 1,

$$-0.097x + 175 \leq y \leq -1.1x + 2030 \qquad \text{Formula 1.}$$

This relationship promotes the move of the nitrogen atoms in the diamond single crystal, and formation of the H3 center and/or the H2 center are further promoted.

When a case where the second step and the third step are performed each once is defined as one cycle, about two cycles can be repeated. This promotes the aggregation of the isolated substitutional nitrogen atoms in the diamond single crystal, and formation of the H3 center and/or the H2 center are promoted. However, excessive repetition may cause a decrease in the H3 center or the H2 center depending on the temperature condition.

[Supplement 1]

The synthetic single crystal diamond of the present disclosure preferably contains nitrogen atoms at 150 ppm or more and 850 ppm or less in terms of number of atoms.
The synthetic single crystal diamond of the present disclosure preferably contains nitrogen atoms at 250 ppm or more and 850 ppm or less in terms of number of atoms.

[Supplement 2]

The synthetic single crystal diamond of the present disclosure preferably contains one or both of the H3 center and the H2 center.

[Supplement 3]

In the synthetic single crystal diamond of the present disclosure, the rate b/a is preferably 0.66 or more and 0.90 or less.
In the synthetic single crystal diamond of the present disclosure, the rate b/a is preferably 0.70 or more and 0.90 or less.

[Supplement 4]

In the method for manufacturing the synthetic single crystal diamond of the present disclosure,

the solvent metal is preferably an alloy composed of iron-cobalt-nickel,
the solvent metal contains preferably $Fe_3N$ as the nitrogen supply source, and
a content of the nitrogen supply source in the solvent metal is preferably 0.01 mass% or more and 0.2 mass% or less.

[Supplement 5]

In the method for manufacturing the synthetic single crystal diamond of the present disclosure,
the second step is preferably performed by using electron beam with an irradiation energy of 4.6 MeV or more and 4.8 MeV or less, a current of 2 mA or more and 5 mA or less, and an irradiation time of 30 hours or more and 45 hours or less. Examples
The present embodiment will be more specifically described with Examples. However, the present embodiment is not limited by these Examples.

<Sample 1 to Sample 18>

(First Step)

By using a sample chamber that has constitution illustrated in Fig. 2, a diamond single crystal is synthesized by a temperature-difference method that uses a solvent metal.
An alloy composed of iron-cobalt-nickel is prepared as the solvent metal, and an iron nitride ($Fe_3N$) powder as a nitrogen supply source is added into the alloy. A concentration of iron nitride in the solvent metal is shown in the column "Iron nitride concentration in solvent metal (mass%)" in "Manufacturing conditions" in Table 1. For example, in Sample 3, the concentration of iron nitride in the solvent metal is 0.01 mass%. In Sample 1 and Sample 2, iron nitride is not added and the concentration of iron nitride in the solvent metal is 0 mass%, but nitrogen with which the solvent metal itself forms a solid solution is contained.
A diamond powder is used for a carbon source, and approximately 0.5 mg of a diamond single crystal is used for a seed crystal. A temperature in the sample chamber is regulated with a heater so that a temperature difference of several tens of degrees is made between a high-temperature portion where the carbon source is disposed and a low-temperature portion where the seed crystal is disposed. This sample is held for 60 hours with regulating a pressure of 5.5 GPa and the temperature in the low-temperature portion in the range of 1370°C$\pm$10°C (1360°C to 1380°C) by using an ultrahigh pressure generator to synthesize a diamond single crystal on the seed crystal. A nitrogen-atom concentration in terms of number of atoms of the obtained diamond single crystal is as shown in the column "Nitrogen-atom concentration in diamond single crystal" in "First step" in Table 1. For example, in Sample 1, the nitrogen-atom concentration in the diamond single crystal is 50 ppm.

(Second Step)

Next, irradiation conditions of electron beam are set to an irradiation beam energy of 4.6 MeV, a current of 2 mA, and an irradiation time of 30 hours. These are irradiation conditions to apply the energy of 100 MGy to the diamond single crystal. In Table 1, samples with described "-" in the column "Electron beam irradiation (100 MGy) " in "Second step" in "Manufacturing conditions" is not irradiated with electron beam.

(Third Step)

Then, heat treatment is performed on the diamond single crystal after the first step or the second step in nitrogen gas under conditions described in columns "Pressure (Pa) " and "Heat treatment (in nitrogen gas) temperature/time" in "Third step" in "Manufacturing conditions" in Table 1 to obtain a synthetic single crystal diamond. For example, in Sample 4, the heat treatment is performed on the diamond single crystal in nitrogen gas at 1600°C for 180 minutes. In Sample 1, Sample 3, and Sample 5, the heat treatment in the third step is not performed.

[Table 1]

Table 1

| Sample No. | Manufacturing conditions | | | | |
|---|---|---|---|---|---|
| | First step | | Second step | Third step | |
| | Iron nitride concentration in solvent metal (mass%) | Nitrogen atom concentration in diamond single crystal (ppm) | Electron beam irradiation | Pressure (Pa) | Heat treatment (in nitrogen gas) temperature/time |
| 1 | 0 | 50 | - | - | - |
| 2 | 0 | 50 | 100MGy | 10 | 1700°C/90 minutes |
| 3 | 0.01 | 150 | - | - | - |
| 4 | 0.01 | 150 | 100MGy | 10 | 1600°C /180 minutes |
| 5 | 0.02 | 250 | - | - | - |
| 6 | 0.02 | 250 | 100MGy | 10 | 1550°C /120 minutes |
| 7 | 0.02 | 250 | 100MGy | 10 | 1650°C /60 minutes |
| 8 | 0.05 | 550 | 100MGy | 10 | 1750°C /60 minutes |
| 9 | 0.05 | 550 | 100MGy | 10 | 1700°C /60 minutes |
| 10 | 0.06 | 650 | - | 10 | 1700°C /60 minutes |
| 11 | 0.06 | 650 | 100MGy | 10 | 1500°C /120 minutes |
| 12 | 0.06 | 650 | 100MGy | 10 | 1600°C /60 minutes |
| 13 | 0.06 | 650 | 100MGy | 10 | 1700°C /60 minutes |
| 14 | 0.06 | 650 | 100MGy | 10 | 1800°C /30 minutes |
| 15 | 0.08 | 850 | 100MGy | 10 | 1700°C /30 minutes |
| 16 | 0.08 | 850 | 100MGy | 10 | 1800°C /30 minutes |
| 17 | 0.02 | 250 | 100MGy | 10 | 1700°C /60 minutes |
| 18 | 0.10 | 1000 | 100MGy | 10 | 1800°C /30 minutes |

<Evaluation>

The synthetic single crystal diamonds of Sample 1 to Sample 18 are subjected to a measurement of a nitrogen-atom concentration, analysis by fluorescence spectrophotometry, analysis by ultraviolet-visible light spectrometry, a measurement of {110}<110>b/a, and analysis by infrared spectrometry.

(Measurement of Nitrogen-Atom Concentration)

A nitrogen-atom concentration in the synthetic single crystal diamond of each sample is determined by SIMS analysis. The results are shown in the column "Nitrogen-atom concentration (ppm)" in "Synthetic single crystal diamond" in Table 2.

(Analysis with Fluorescence Spectrophotometer)

The synthetic single crystal diamond of each sample is processed into a plate with approximately 1 mm in thickness, two surfaces to transmit light are polished with a metal-bonded grindstone so that a surface roughness Ra is 20 nm or less, and then a fluorescence spectrum with a laser excitation wavelength of 457 nm and a fluorescence spectrum with a laser excitation wavelength of 830 nm are produced by using a fluorescence spectrophotometer.

In the fluorescence spectrum of each sample with a laser excitation wavelength of 457 nm, presence or absence of an emission peak within a wavelength range of 503±2 nm and a wavelength range of 510 nm or more and 550 nm or less is checked. The results are shown in the column "503±2 nm / 510 to 550 nm emission peak" in "Fluorescence spectrum (457 nm laser excitation)" in "Synthetic single crystal diamond" in Table 2. In the column, "presence" represents presence of the emission peak within one or both of the above ranges, and presence of the H3 center in the synthetic single crystal diamond. In the column, "absence" represents absence of the emission peak within neither of the above ranges, and absence of the H3 center in the synthetic single crystal diamond.

In the fluorescence spectrum of each sample with a laser excitation wavelength of 830 nm, presence or absence of an emission peak within a wavelength range of 986±2 nm and a wavelength range of 1000 nm or more and 1300 nm or less is checked. The results are shown in the column "986±2 nm / 1000 to 1300 nm emission peak" in "Fluorescence spectrum (830 nm laser excitation)" in "Synthetic single crystal diamond" in Table 2. In the column, "presence" represents presence of the emission peak within one or both of the above ranges, and presence of the H2 center in the synthetic single crystal diamond. In the column, "absence" represents absence of the emission peak within neither of the above ranges, and absence of the H2 center in the synthetic single crystal diamond.

(Analysis with Ultraviolet-Visible Light Spectrophotometer)

With each sample prepared in the analysis with the fluorescence spectrophotometer, an absorption spectrum is produced by using an ultraviolet-visible light spectrophotometer.

In the absorption spectrum of each sample, presence or absence of an absorption peak within a wavelength range of 503±2 nm and a wavelength range of 470 nm or more and 550 nm or less is checked. The results are shown in the column "503±2 nm / 470 to 500 nm absorption peak" in "Absorption spectrum" in "Synthetic single crystal diamond" in Table 2. In the column, "presence" represents presence of the absorption peak within one or both of the above ranges, and presence of the H3 center in the synthetic single crystal diamond. In the column, "absence" represents absence of the absorption peak within neither of the above ranges, and absence of the H3 center in the synthetic single crystal diamond.

In the absorption spectrum of each sample, presence or absence of an absorption peak within a wavelength range of 986±2 nm and a wavelength range of 750 nm or more and 950 nm or less is checked. The results are shown in the column "986±2 nm / 750 to 950 nm absorption peak" in "Absorption spectrum" in "Synthetic single crystal diamond" in Table 2. In the column, "presence" represents presence of the absorption peak within one or both of the above ranges, and presence of the H2 center in the synthetic single crystal diamond. In the column, "absence" represents absence of the absorption peak within neither of the above ranges, and absence of the H2 center in the synthetic single crystal diamond.

(Measurement of {110}<110>b/a)

With the synthetic single crystal diamond of each sample, {110}<110>b/a is measured. Since the specific measurement method has been described in Embodiment 1, the description is not repeated. The results are shown in the column "{110}<110>b/a" in "Synthetic single crystal diamond" in Table 2. A lower value of b/a indicates larger elastic deformability, higher toughness, and more excellent breakage resistance.

(Analysis by Infrared Spectrometry)

With each sample prepared in the analysis by the fluorescence spectrophotometry, an infrared absorption spectrum is produced by using an infrared spectrophotometer.

In the infrared absorption spectrum of each sample, presence or absence of an absorption peak within a range of a wavenumber of $1130 \pm 2$ cm$^{-1}$ is checked. Since the synthetic single crystal diamond is judged to contain the isolated substitutional nitrogen atoms when such an absorption peak is present, "presence" is described in the column "Isolated substitutional nitrogen atom" in Table 2. Since the synthetic single crystal diamond is judged to contain no isolated substitutional nitrogen atom when such an absorption peak is absent, "absence" is described in the column "Isolated substitutional nitrogen atom" in Table 2.

[Table 2]

Table 2

| Sample No. | Synthetic single crystal diamond | | | | | | | | |
| --- | --- | --- | --- | --- | --- | --- | --- | --- | --- |
| | Nitrogen-atom concentration (ppm) | Fluorescence spectrum (457 nm laser excitation) | Absorption spectrum | H3 center | Fluorescence spectrum (830 nm laser excitation) | Absorption spectrum | H2 center | Isolated substitutional nitrogen atom | {110} < 110> b/a |
| | | 503±2 nm / 510 to 550 nm emission peak | 503±2 nm / 470 to 500 nm absorption peak | | 986±2 nm / 1000 to 1300 nm emission peak | 986±2 nm / 750 to 950 nm absorption peak | | | |
| 1 | 50 | absence | absence | absence | absence | absence | absence | presence | 0.960 |
| 2 | 50 | presence | presence | presence | presence | presence | presence | absence | 0.900 |
| 3 | 150 | absence | absence | absence | absence | absence | absence | presence | 0.948 |
| 4 | 150 | presence | presence | presence | presence | presence | presence | absence | 0.852 |
| 5 | 250 | presence | presence | presence | absence | absence | absence | presence | 0.924 |
| 6 | 250 | presence | presence | presence | presence | presence | presence | absence | 0.840 |
| 7 | 250 | presence | presence | presence | presence | presence | presence | absence | 0.840 |
| 8 | 550 | presence | presence | presence | presence | presence | presence | absence | 0.839 |
| 9 | 550 | presence | presence | presence | presence | presence | presence | absence | 0.842 |
| 10 | 650 | presence | presence | presence | absence | absence | absence | absence | 0.960 |
| 11 | 650 | presence | presence | presence | presence | presence | presence | presence | 0.888 |
| 12 | 650 | presence | presence | presence | presence | presence | presence | absence | 0.852 |
| 13 | 650 | presence | presence | presence | presence | presence | presence | absence | 0.792 |
| 14 | 650 | presence | presence | presence | presence | presence | presence | absence | 0.744 |
| 15 | 850 | presence | presence | presence | presence | presence | presence | absence | 0.720 |
| 16 | 850 | presence | presence | presence | presence | presence | presence | absence | 0.696 |
| 17 | 250 | presence | presence | presence | presence | presence | presence | absence | 0.840 |
| 18 | 1000 | presence | presence | presence | presence | presence | presence | absence | 0.660 |

EP 4 357 491 A1

< Discussions>

Sample 2, Sample 4, Sample 6 to Sample 9, and Sample 11 to Sample 18 correspond to Examples. Sample 1, Sample 3, Sample 5, and Sample 10 correspond to Comparative Examples. In Sample 2, Sample 4, Sample 6 to Sample 9, and Sample 11 to Sample 18 (Examples), the value of {110}<110>b/a is 0.90 or less, and these samples are confirmed to have large elasticity and excellent breakage resistance. These samples of Examples exhibit a smaller value of {110}<110>b/a than Sample 1, Sample 3, Sample 5, and Sample 10 (Comparative Examples), and the breakage resistance is confirmed to be excellent. Since containing the H2 center and the H3 center, these samples of Examples are judged to have high hardness, high strength, and excellent wear resistance.

In Sample 5, the second step and the third step are not performed but the obtained synthetic single crystal diamond contains the H3 center. The reason is presumed that a part of a nitrogen impurity aggregates to generate the H3 center during the synthesis of the diamond single crystal in the first step. Although Sample 5 contains the H3 center, {110}<110>b/a is more than 0.90, and thereby the breakage resistance is deteriorated compared with Examples.

In Sample 10, the second step is not performed but the obtained synthetic single crystal diamond contains the H3 center. The reason is presumed that a part of a nitrogen impurity aggregates to generate the H3 center during the synthesis of the diamond single crystal in the first step. Although Sample 10 contains the H3 center, {110}<110>b/a is more than 0.90, and thereby the breakage resistance is deteriorated compared with Examples.

The embodiments and Examples of the present disclosure have been described as above, but appropriate combinations and various modifications of the constitution of the above each embodiment and Example are anticipated in advance.

The embodiments and Examples disclosed herein are examples in all the points, and should not be considered to be limitative. The scope of the present invention is described by not the aforementioned embodiments and Examples but the claims, and intended to encompass means equivalent to the claims and all modifications within the scope of the claims.

REFERENCE SIGNS LIST

1 Diamond single crystal; 2 Insulator; 3 Carbon source; 4 Solvent metal; 5 Seed crystal; 6 Pressure medium; 7 Graphite heater; 10 Sample chamber

**Claims**

1. A synthetic single crystal diamond, comprising nitrogen atoms at a concentration of 50 ppm or more and 1000 ppm or less in terms of number of atoms, wherein

   the synthetic single crystal diamond contains an aggregate composed of one vacancy and two substitutional nitrogen atoms present adjacent to the vacancy,
   a ratio b/a of a length "b" of a longer diagonal line of a second Knoop indentation to a length "a" of a longer diagonal line of a first Knoop indentation is 0.90 or less on the synthetic single crystal diamond,
   the first Knoop indentation is an indentation formed on a surface of the synthetic single crystal diamond in a state where a Knoop indenter is pressed in a <110> direction of a {110} plane of the synthetic single crystal diamond in accordance with JIS Z 2251:2009 under conditions of a temperature of 23°C±5°C and a test load of 4.9 N, and
   the second Knoop indentation is a Knoop indentation remaining on the surface of the synthetic single crystal diamond after the test load is released.

2. The synthetic single crystal diamond according to Claim 1, wherein in a fluorescence spectrum obtained by irradiating the synthetic single crystal diamond with excitation light at a wavelength of 457 nm by using a fluorescence spectrophotometer, an emission peak is present within one or both of a wavelength range of 503±2 nm and a wavelength range of 510 nm or more and 550 nm or less.

3. The synthetic single crystal diamond according to Claim 1 or 2, wherein in an absorption spectrum of the synthetic single crystal diamond obtained by using an ultraviolet-visible light spectrophotometer, an absorption peak is present within one or both of a wavelength range of 503±2 nm and a wavelength range of 470 nm or more and 500 nm or less.

4. The synthetic single crystal diamond according to any one of Claims 1 to 3, wherein in a fluorescence spectrum obtained by irradiating the synthetic single crystal diamond with excitation light at a wavelength of 830 nm by using a fluorescence spectrophotometer, an emission peak is present within one or both of a wavelength range of $986 \pm 2$ nm and a wavelength range of 1000 nm or more and 1300 nm or less.

5. The synthetic single crystal diamond according to any one of Claims 1 to 4, wherein in an absorption spectrum of the synthetic single crystal diamond obtained by using an ultraviolet-visible light spectrophotometer, an absorption peak is present within one or both of a wavelength range of $986 \pm 2$ nm and a wavelength range of 750 nm or more and 950 nm or less.

6. The synthetic single crystal diamond according to any one of Claims 1 to 5, wherein the synthetic single crystal diamond contains no isolated substitutional nitrogen atom.

7. A method for manufacturing the synthetic single crystal diamond according to any one of Claims 1 to 6, the method comprising:

a first step of synthesizing a diamond single crystal that contains nitrogen atoms at a concentration of 50 ppm or more and 1000 ppm or less in terms of number of atoms by a temperature-difference method that uses a solvent metal;
a second step of irradiating the diamond single crystal with one or both of electron beam and particle beam to apply energy of 10 MGy or more and 1000 MGy or less; and
a third step of performing heat treatment on the diamond single crystal after the second step, in an inert gas at a pressure of 1 Pa or more and 100 KPa or less to obtain the synthetic single crystal diamond,
wherein a temperature "x" in the heat treatment in the third step is 1500°C or more and 1800°C or less, and a heating time "y" is 1 minute or more and 360 minutes or less.

8. The method for manufacturing the synthetic single crystal diamond according to Claim 7, wherein the temperature "x"°C and the heating time "y" minutes in the third step satisfy the following Formula 1,

$$-0.097x + 175 \leq y \leq -1.1x + 2030 \qquad \text{Formula 1.}$$

FIG.1

SECOND KNOOP
INDENTATION

FIRST KNOOP
INDENTATION
(BEFORE ELASTIC
RECOVERY)

ELASTIC
RECOVERY

STRIPE-SHAPED
INDENTATION

STRIPE-SHAPED
INDENTATION

ELASTIC
RECOVERY

b1

b2

b

a

FIG.2

6

10

7

2

3

$T_{high}$

1

1

4

1

$T_{low}$

5

5

5

6

6

6

| INTERNATIONAL SEARCH REPORT | International application No. |
|---|---|
| | **PCT/JP2022/019527** |

**A. CLASSIFICATION OF SUBJECT MATTER**

*C30B 29/04*(2006.01)i; *B23B 27/14*(2006.01)i; *B23B 27/20*(2006.01)i; *C30B 9/10*(2006.01)i; *C30B 33/04*(2006.01)i
FI: C30B29/04 U; C30B9/10; C30B33/04; B23B27/20; B23B27/14 B

According to International Patent Classification (IPC) or to both national classification and IPC

**B. FIELDS SEARCHED**

Minimum documentation searched (classification system followed by classification symbols)

C30B29/04; B23B27/14; B23B27/20; C30B9/10; C30B33/04

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2021/106283 A1 (SUMITOMO ELECTRIC INDUSTRIES) 03 June 2021 (2021-06-03) paragraphs [0097]-[0121], table 1 | 1-8 |
| X | WO 2019/077888 A1 (SUMITOMO ELECTRIC INDUSTRIES) 25 April 2019 (2019-04-25) paragraphs [0052]-[0074], table 1 | 1-8 |
| A | JP 2018-58745 A (SUMITOMO ELECTRIC INDUSTRIES) 12 April 2018 (2018-04-12) entire text, all drawings | 1-8 |
| A | JP 2020-11887 A (SUMITOMO ELECTRIC INDUSTRIES) 23 January 2020 (2020-01-23) entire text, all drawings | 1-8 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 July 2022** | **19 July 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/019527**

| Patent document cited in search report | | | Publication date (day/month/year) | Patent family member(s) | Publication date (day/month/year) |
|---|---|---|---|---|---|
| WO | 2021/106283 | A1 | 03 June 2021 | (Family: none) | |
| WO | 2019/077888 | A1 | 25 April 2019 | US 2020/0325596 A1 paragraphs [0060]-[0095], table 1 EP 3699329 A1 CN 111247275 A KR 10-2020-0072483 A | |
| JP | 2018-58745 | A | 12 April 2018 | (Family: none) | |
| JP | 2020-11887 | A | 23 January 2020 | (Family: none) | |

Form PCT/ISA/210 (patent family annex) (January 2015)

**EP 4 357 491 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021099431 A